# EUROPEAN PATENT SPECIFICATION

(11) **EP 2 290 706 B1**
(45) Date of publication and mention of the grant of the patent: **25.07.2018**
(21) Application number: 10151573.2
(22) Date of filing: 25.01.2010
(51) Int. Cl.: H01L 33/00, B23K 26/40

(54) **Method of fabricating light emitting diode using laser lift-off technique and using laser lift-off apparatus having heater**
Verfahren zur Herstellung einer Leuchtdiode unter Anwendung einer Laserablösetechnik und einer Laserablösevorrichtung mit Heizgerät
Procédé de fabrication de diode électroluminescente à l'aide d'une technique de retrait au laser et d'un appareil de retrait au laser doté d'un chauffage

(30) Priority: 26.08.2009 KR 20090079438
(43) Date of publication of application: 02.03.2011
(73) Proprietor: Seoul Viosys Co., Ltd, Ansan-si, Gyeonggi-do (KR)
(72) Inventor: Kim, Chang Youn, 425-851, Ansan-si, Gyeonggi-do (KR); Kim, Joon Hee, 425-851, Ansan-si, Gyeonggi-do (KR); You, Jong Kyun, 425-851, Ansan-si, Gyeonggi-do (KR); Kim, Hwa Mok, 425-851, Ansan-si, Gyeonggi-do (KR)
(74) Representative: Isarpatent

(56) References cited:
- JP-A- 2003 264 314
- JP-A- 2006 173 147
- US-A1- 2003 089 906

## Description

### BACKGROUND OF THE INVENTION

### FIELD OF THE INVENTION

The present disclosure relates to a method of fabricating a light emitting diode and a method of fabricating a light emitting diode using a laser lift-off apparatus and, more particularly, to a method of fabricating a light emitting diode using a laser lift-off technique.

### DISCUSSION OF THE BACKGROUND

In recent years, good thermal stability and direct transition type energy band of group III-based nitrides, such as gallium nitride GaN, aluminum nitride AlN and the like, have attracted considerable attention to the group III-based nitrides as materials for light emitting diodes in the range of visible light and UV light. Particularly, InGaN-based blue and green light emitting diodes are used for a variety of applications such as large natural color flat display panels, traffic signals, interior lighting, high density light sources, high resolution output systems, optical communication, and the like.

A group III-based nitride semiconductor layer is grown on a heterogeneous substrate having a similar crystal structure to that of the semiconductor layer by metal organic chemical vapor deposition (MOCVD) or molecular beam epitaxy (MBE), since it is difficult to fabricate a homogeneous substrate that permits growth of the semiconductor layer thereon. A sapphire substrate with the hexagonal structure is generally used as the heterogeneous substrate. However, since sapphire is an electrical insulator, the use of sapphire limits the structure of light emitting diodes. Thus, recent studies have focused on development of a technique which can enable growth of epitaxial layers including nitride semiconductor layers on a heterogeneous substrate such as a sapphire substrate, followed by lifting-off the heterogeneous substrate from the epitaxial layers to thereby fabricate a vertical structure type light emitting diode.

As a method of lifting-off the heterogeneous substrate, a laser lift-off technique is generally used. In the laser lift-off technique, a second substrate is bonded to the top of the epitaxial layers grown on the heterogeneous substrate, for example, a sapphire substrate, and a laser beam is then irradiated through the sapphire substrate to lift-off the substrate from the epitaxial layers. Here, it is difficult in view of optics to form the laser beam with the size of the sapphire substrate. Thus, a laser beam having a final chip size is generally used for line scanning.

According to such a conventional technique, when the second substrate is a homogeneous substrate to the sapphire substrate or has a similar coefficient of thermal expansion to that of the sapphire substrate, lift-off of the sapphire substrate by laser beam irradiation can be performed without significant problems. However, when the second substrate has a different coefficient of thermal expansion from that of the sapphire substrate, the epitaxial layers often undergo cracking or fracture during separation of the sapphire substrate using the laser lift-off technique. Furthermore, the difference in thermal coefficient between the second substrate and the sapphire substrate often causes bowing of the sapphire substrate after the second substrate is bonded to the epitaxial layers. The bowing of the sapphire substrate causes the laser beam to be out of focus depending on locations of the sapphire substrate, thereby making it difficult to accurately transfer energy of the laser beam to an interface between the sapphire substrate and the epitaxial layer.

### SUMMARY OF THE INVENTION

The present disclosure is directed to solving the problems of the conventional technique as described above, and one embodiment includes a method of fabricating a light emitting diode, which can prevent cracking or fracture in epitaxial layers during separation of a substrate using a laser lift-off technique.

Another embodiment includes a method of fabricating a light emitting diode, which can relieve bowing of a growth substrate to facilitate focusing of a laser beam during separation of a substrate using a laser lift-off technique.

A further embodiment includes a method of fabricating a light emitting diode using a laser lift-off apparatus capable of preventing cracking or fracture in epitaxial layers during separation of a substrate using a laser lift-off technique.

Still another embodiment includes a method of fabricating a light emitting diode using a laser lift-off apparatus capable of relieving bowing of a growth substrate to facilitate focusing of a laser beam during separation of a substrate using a laser lift-off technique.

In accordance with one aspect, a method of fabricating a light emitting diode using a laser lift-off technique is provided. The method includes: growing epitaxial layers on a first substrate, the epitaxial layers including a first conductive-type compound semiconductor layer, an active layer and a second conductive-type compound semiconductor layer; bonding a second substrate having a different coefficient of thermal expansion from that of the first substrate to the top of the epitaxial layers at a first temperature of the first substrate higher than room temperature; and separating the first substrate from the epitaxial layers by irradiating a laser beam through the first substrate at a second temperature of the first substrate higher than room temperature but not more than the first temperature.

In a conventional laser lift-off technique, after the second substrate is bonded at the first temperature, the first substrate is cooled to room temperature and then separated from the epitaxial layers by irradiating a laser beam through the first substrate. Here, the difference in coefficient of thermal expansion between the first substrate and the second substrate causes bowing of the first substrate and the epitaxial layers are liable to undergo cracking or fracture during separation of the first substrate by irradiating the laser beam.

On the contrary, according to this aspect, the laser beam is irradiated at the second temperature of the first substrate higher than room temperature. Therefore, with the bowing of the first substrate relieved, the first substrate can be separated from the epitaxial layers, thereby preventing generation of cracking or fracture in the epitaxial layers.

Meanwhile, the first substrate can be heated to the second temperature before irradiating the laser beam. For example, after the second substrate is bonded to the top of the epitaxial layers, the first substrate may be first cooled to room temperature. Then, the first substrate may be heated to the second temperature by a heater. Additionally, during irradiation of the laser beam, the first substrate may be heated and maintained at the second temperature. Document JP2003 264314 A discloses a lift-off technique for a light emitting diode according to this aspect. Alternatively, according to the present invention, after the second substrate is bonded to the epitaxial layers at the first temperature, the laser beam is irradiated through the first substrate before the first substrate is cooled to room temperature.

Heating of the first substrate may be performed using heat conduction, convection or radiation. For example, a resistance heater, an IR lamp and/or a heat gun may be used to heat the first substrate. These heaters may be located inside a laser lift-off apparatus.

If the first substrate is a 2-inch sapphire substrate, the second temperature may be a temperature at which an average value of bowing of the first substrate is not more than 3 mm. The second temperature may be a temperature at which an average value of bowing of the first substrate is not more than 1.5 mm.

The second substrate may be bonded to the epitaxial layers through, although not limited to, eutectic bonding of a bonding metal. Here, the bonding metal may be AuSn. In this case, the second temperature may be in the range of 200∼300°C.

According to embodiments of the present disclosure, the total thickness of the epitaxial layers does not exceed 10 µm. Such a total thickness of the epitaxial layers is a relatively much smaller thickness which does not exceed 1/10th the thickness of the first and second substrates. Accordingly, substrate bowing caused by the difference in coefficient of thermal expansion between the epitaxial layers and the first substrate may be so insignificant as to be ignored.

In accordance with another aspect, a laser lift-off apparatus including a heater is provided. The apparatus includes: a laser oscillator emitting a laser beam; a stage supporting a work piece; and a heater heating the work piece.

The work piece may include a first substrate; epitaxial layers grown on the first substrate; and a second substrate bonded to the epitaxial layers.

According to the above aspect aspect, the first substrate may be heated using the heater. Therefore, with the bowing of the first substrate relieved, a laser beam can be irradiated through the first substrate, thereby preventing generation of cracking or fracture in the epitaxial layers.

In one embodiment, the heater may be a resistance heater. Further, the stage may include a movable main stage and the resistance heater may be disposed on the main stage. Alternatively, the resistance heater may be disposed inside the main stage.

The stage may further include an insulator between the main stage and the resistance heater, a heater securing plate located on the resistance heater, and securing pins securing the heater securing plate. The insulator, the heater securing plate and/or the securing pins may be made of ceramics or plastics. The insulator, the heater securing plate and/or the securing pins may be made of the same material.

In another embodiment, the heater may be an IR lamp or a heat gun.

### BRIEF DESCRIPTION OF THE DRAWINGS

Figures 1 to 5 are schematic cross-sectional views showing respective processes in a method of fabricating a light emitting diode;
Figure 6 is a graph depicting bowing of a first substrate depending on heating temperature after bonding a second substrate;
Figure 7 is a schematic view of a laser lift-off apparatus;
Figure 8 is a cross-sectional view of a stage including a resistance heater; and
Figure 9 is a cross-sectional view of a stage including an IR lamp or a heat gun.

### DETAILED DESCRIPTION OF THE INVENTION

Embodiments of the present disclosure will now be described in detail with reference to the accompanying drawings. The following embodiments are given by way of illustration to provide a thorough understanding of the invention to those skilled in the art. Likewise, it should be noted that the drawings are not to precise scale and some of the dimensions are exaggerated for clarity of description in the drawings. In addition, like elements are denoted by like reference numerals throughout the specification and drawings.

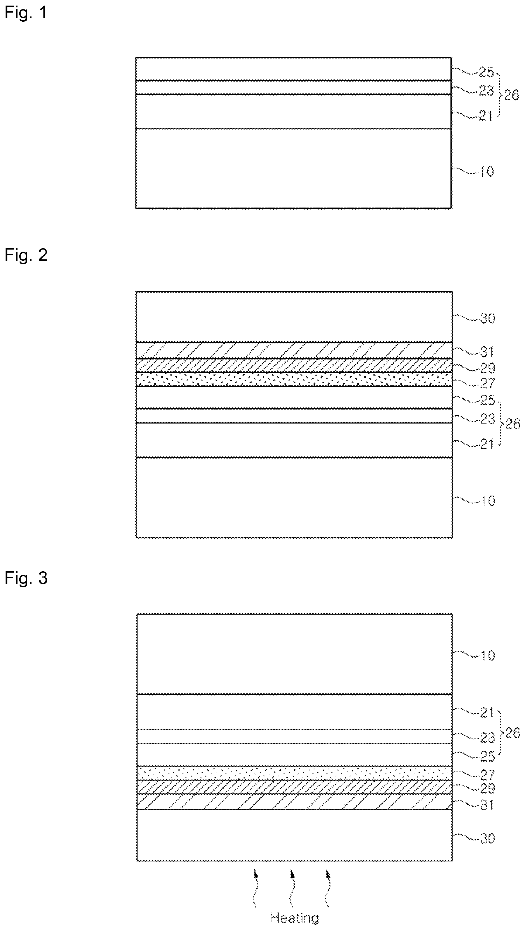

Figures 1 to 5 illustrate respective operations in a method of fabricating a light emitting diode using a laser lift-off technique.

Referring to Figure 1, epitaxial layers 26 including a first conductive-type compound semiconductor layer 21, an active layer 23 and a second conductive-type compound semiconductor layer 25 are formed on a first substrate 10. The first substrate 10 may be a growth substrate, for example, a sapphire substrate, on which the epitaxial layers 16 are grown.

The epitaxial layers 26 may be gallium nitride-based compound semiconductors grown on the first substrate 10 by MOCVD or MBE. Although not shown in the drawings, the epitaxial layers 26 may include a buffer layer for relieving lattice mismatch between the first substrate 10 and the epitaxial layers 26 grown thereon. Further, the active layer 23 may have a single or multi-quantum well structure. The first and second conductive-type compound semiconductors may be n-type and p-type semiconductors or p-type and p-type semiconductors, respectively.

The epitaxial layers 26 may be formed to have a total thickness less than 10 µm. The total thickness of the epitaxial layers 26 is relatively much smaller than the thickness of the first substrate 10 that is used as the growth substrate. For example, since the first substrate 10 generally has a thickness of 100 µm or more, the thickness of the epitaxial layers 26 does not exceed 1/10th the thickness of the first substrate 10. As such, the epitaxial layers 26 may be formed to have a total thickness less than 10 µm, thereby relatively reducing stress applied from the epitaxial layers 26 to the first substrate 10.

The epitaxial layers 26 are grown in a vacuum chamber. After the growth of the epitaxial layers 26, the first substrate 10 having the epitaxial layers 26 thereon is taken out of the chamber for a subsequent process.

Referring to Figure 2, a second substrate 30 is bonded to the uppermost layer of the epitaxial layers 26, for example, the second conductive-type compound semiconductor layer 25. The second substrate 30 may be variously selected depending on the use thereof in consideration of heat conduction, electric conduction and the like, and, for example, may be a silicon substrate or a metal substrate. Particularly, when fabricating a vertical light emitting diode, the second substrate 30 is a conductive substrate. The second substrate 30 generally has a different coefficient of thermal expansion than that of the first substrate 10.

The second substrate 30 may be bonded to the epitaxial layers 26 by eutectic bonding of a bonding metal 31. The bonding metal 31 may be AuSn, which has a melting point of about 330 °C. A bonding metal having a higher melting point than AuSn may also be used. After the bonding metal 31 is formed on one side of the epitaxial layers 26 and on the opposite side of the second substrate 30, the bonding metal 31 is heated to, for example, about 300 °C to cause eutectic bonding, so that the second substrate 30 is bonded to the epitaxial layers 26.

Before forming the bonding metal 31, a reflective layer 27 and a diffusion barrier layer 29 may be formed on the epitaxial layers 26. The reflective layer 27 enhances light output by reflecting light that is generated from the active layer 23 and travels toward the second substrate 30. The reflective layer 27 may be in ohmic contact with the second conductive-type semiconductor layer 25 and formed of Al, Ag, Ni, Ph, Pd, Pt, Ru or an alloy thereof. The diffusion barrier layer 29 prevents deterioration of reflectivity of the reflective layer 27, which can be caused by diffusion of the bonding metal 31 into the reflective layer 27.

Referring to Figure 3, after bonding of the second substrate 30, the first substrate 10 and the second substrate 30 may first be cooled to room temperature. Then, the first substrate 10 is placed in a laser lift-off apparatus to separate the first substrate 10.

Before laser irradiation, the first substrate 10 is heated above room temperature. Here, considering the melting point of the bonding metal, the temperature of the first substrate 10, that is, the second temperature, may not exceed the first temperature, that is, the eutectic temperature. If the second temperature exceeds the first temperature, the epitaxial layers 26 can be fractured due to excessive thermal expansion of the bonding metal. Therefore, if the bonding metal 31 is, for example, AuSn, the first substrate 10 may be heated to a temperature of 300 °C or less, preferably in the range of 200∼300 °C.

The first substrate 10 may be heated in a laser lift-off apparatus particularly fabricated to include a heating means, that is, a heater, as described below. Alternatively, in the present invention after being heated outside a laser lift-off apparatus, the first substrate 10 is shifted into the laser lift-off apparatus before being cooled to room temperature.

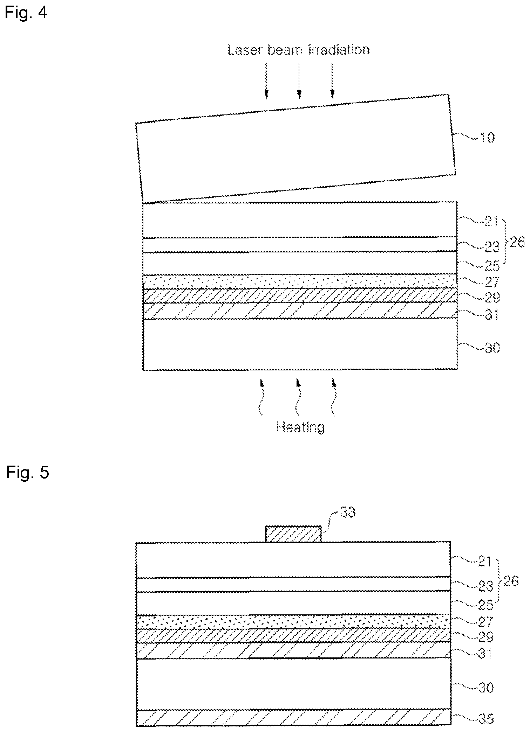

Then, referring to Figure 4, a laser beam is irradiated through the first substrate 10 to separate the first substrate 10 from the epitaxial layers 26. Here, the temperature of the first substrate 10 is higher than room temperature and does not exceed the first temperature. Accordingly, stress applied to the first or second substrate 10 or 30 due to the difference in coefficient of thermal expansion between the first and second substrates 10, 30 is relieved. As a result, bowing of the first substrate 10 can be relieved to thereby facilitate focusing of the laser beam, and the epitaxial layers 26 can be prevented from suffering cracking or fracture during partial separation of the first substrate 10.

Referring to Figure 5, after separation of the first substrate 10, an electrode pad 33 is formed on an exposed surface of the first conductive-type compound semiconductor layer 21, and an electrode pad 35 is formed on the second substrate 30. Then, the epitaxial layers 26 including the second substrate 30 are divided into individual light emitting diodes, thereby completing fabrication of vertical structure type light emitting diodes.

In this aspect, the first substrate 10 is described as being heated before the laser irradiation. Alternatively, according to the invention, after the second substrate 30 is bonded to the epitaxial layers 26, the first substrate 10 is shifted into the laser lift-off apparatus while being cooled, and is then separated from the epitaxial layers 26 by irradiating the laser beam thereto.

Further, although the second substrate 30 is described as being bonded to the epitaxial layers 26 via the bonding metal 31 in this embodiment, the second substrate 30 may also be bonded thereto by other techniques.

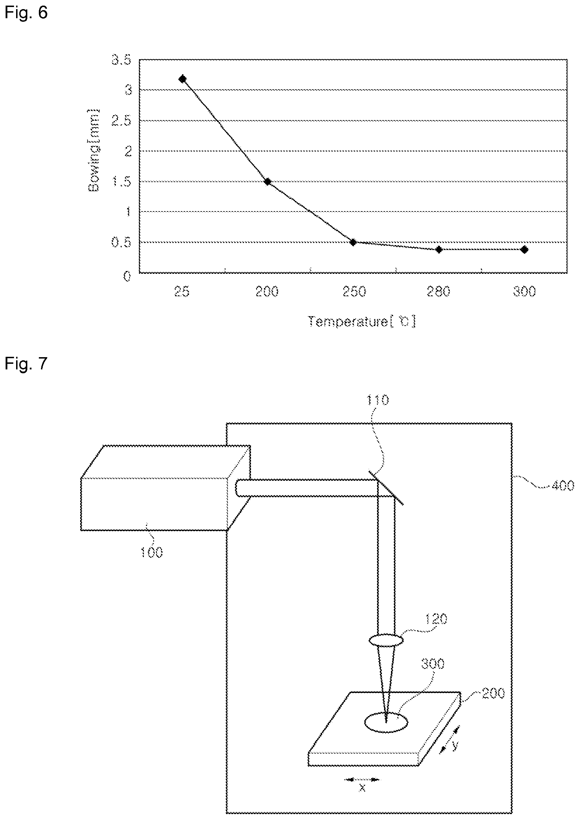

Figure 6 is a graph depicting bowing of the second substrate 30 depending on heating temperature after the second substrate 30 is bonded to the epitaxial layers 26. Here, the first substrate 10 is a 2-inch sapphire substrate and the second substrate 30 is a silicon substrate and is bonded to the epitaxial layers 26 at 300 °C by AuSn-eutectic bonding. Herein, a degree of bowing is an average value obtained by measuring the height of respective edges of the second substrate 30 with a wafer placed on a flat surface to allow the second substrate 30 to contact the flat surface.

Referring to Figure 6, after the second substrate 30 is bonded to the epitaxial layers, the degree of bowing reaches about 3.2 mm at room temperature. Then, as the wafer is heated, the degree of bowing is lowered. At 200 °C, the degree of bowing is lowered below 1/2 the bowing degree at room temperature, and at 250 °C, the degree of bowing is lowered to 0.5 mm or less and is not further significantly lowered even by additional heating.

Accordingly, it can be seen that after the second substrate 30 is bonded to the epitaxial layers, the bowing of the first substrate 10 can be relieved by heating the first substrate 10. The above example was obtained using the 2-inch sapphire substrate, and the degree of bowing is expected to linearly increase in proportion to the size of the sapphire substrate.

In the example of Figure 6, it can be seen that, when the 2-inch sapphire substrate is used as the first substrate 10, the first substrate 10 may be heated to a temperature at which the degree of bowing becomes at least 3 mm or less, preferably 1.5 mm or less.

Figure 7 is a schematic view of a laser lift-off apparatus in accordance with one embodiment of the present disclosure.

Referring to Figure 7, the laser lift-off apparatus includes a laser oscillator 100 oscillating a laser beam, a mirror 110 changing a traveling direction of the laser beam, an optical lens 120 focusing the laser beam, and a stage 200 supporting a work piece, that is, a wafer 300, provided as an irradiation target of the laser beam. The apparatus may include a housing 400 that has a laser beam path defined therein to maintain the path in a vacuum.

The laser oscillator 100 may be a KrF or ArF excimer laser. A beam emitted from the laser oscillator 100 is reflected by the mirror 110 and changed in traveling direction. The apparatus may include a plurality of mirrors 110 to change the traveling direction of the laser beam. The optical lens 120 is located above the stage 200 and focuses the laser beam entering the wafer 300.

The stage 200 may be moved in the x- and/or y-directions by a shifting device (not shown) so that the wafer 300 thereon may also be moved. The wafer 300 includes a first substrate 10, epitaxial layers 26 grown on the first substrate 10, and a second substrate 30 bonded to the epitaxial layers 26. A laser beam is irradiated through the first substrate 10 and absorbed mainly by an interface between the first substrate 10 and the epitaxial layers 26. The laser beam may be irradiated in the form of a spot beam and scan across the wafer 300 by movement of the wafer 300.

Further, the stage 200 includes a heater, which is used to heat the wafer 300 before or during the laser irradiation.

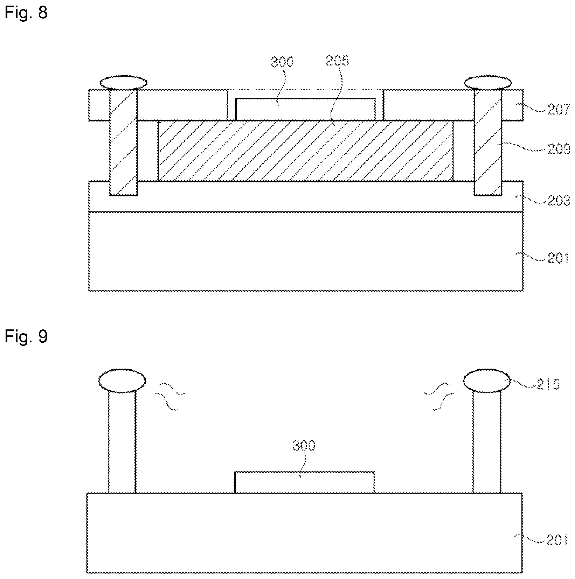

Figure 8 is a cross-sectional view of a stage including a resistance heater as a heater in accordance with one embodiment of the present disclosure.

Referring to Figure 8, the stage 200 may include a main stage 201, a resistance heater 205, an insulator 203, a heater securing plate 207, and securing pins 209. The main stage 201 supports the resistance heater 205 and the wafer 300 and serves to move the wafer 300 in the x- and/or y-directions by the shifting device.

The resistance heater 205 generates resistance heat using electric power from a power source. The resistance heat is transferred from the resistance heater 205 to the work piece 300 contacting the resistance heater 205 so that the work piece 300 is heated by the resistance heat.

The insulator 203 insulates the main stage 201 from the resistance heater 205 and shields heat transfer from the resistance heater 205 to the main stage 201 to thereby improve heat efficiency. The insulator 203 may be made of, for example, ceramics or plastics, and may be secured to the main stage 201.

The heater securing plate 207 is disposed on the heater 205 to secure the resistance heater 205 between the main stage 201 and the heater securing plate 207. The heater securing plate 207 is secured to the main stage 201 or the insulator 203 by securing screws or securing pins 209. The heater securing plate 207 and the securing pins 209 may also be made of ceramics or plastics.

In this embodiment, the resistance heater 205 is described as being disposed on the main stage 201, but it may also be disposed inside the main stage 201.

According to this embodiment, since the wafer 300 can be heated using the resistance heater 205, wafer bowing may be relieved by heating the work piece 300 before and/or during the laser irradiation.

Figure 9 is a cross-sectional view of a stage including an IR lamp or a heat gun as a heater in accordance with one embodiment of the present disclosure.

Referring to Figure 9, a heater such as an IR lamp or a heat gun is disposed above the main stage 201. The IR lamp may heat the wafer 300 on the main stage 201 by emitting infrared light thereto, and the heat gun may heat the wafer 300 by forcible convection of resistance heat.

In the above description, several heaters for heating the wafer are described, but various other heaters may also be used for heating the wafer by heat conduction, convection and/or radiation.

According to the embodiments, during separation of a growth substrate by the laser lift-off technique, bowing of the growth substrate is relieved to facilitate focusing of a laser beam and to prevent generation of cracking or fracture in epitaxial layers. Further, the growth substrate may be heated using the heater of the laser lift-off apparatus.

## Claims

1. A method of fabricating a light emitting diode, comprising:
growing epitaxial layers on a first substrate, the epitaxial layers comprising a first conductive-type compound semiconductor layer, an active layer, and a second conductive-type compound semiconductor layer;
bonding a second substrate having a different coefficient of thermal expansion from that of the first substrate to the epitaxial layers at a first temperature of the first substrate higher than room temperature; and
separating the first substrate from the epitaxial layers by irradiating a laser beam through the first substrate at a second temperature of the first substrate higher than room temperature but not more than the first temperature, **characterised in that**, irradiation of the laser beam is performed while the first substrate is cooled after the second substrate is bonded to the epitaxial layers.

2. The method according to claim 1, wherein the second substrate is bonded to the epitaxial layers by eutectic bonding of a bonding metal.

3. The method according to claim 2, wherein the bonding metal is AuSn.

4. The method according to claim 3, wherein the second temperature is in the range of 200-300 °C.

5. The method according to claim 1, wherein a total thickness of the epitaxial layers is less than 10 *µ*m.

6. A method according to anyone of claims 1-5 applied using a laser lift-off apparatus, wherein the laser lift-off apparatus comprises:
a laser oscillator emitting a laser beam;
a stage supporting a work piece; and
a heater heating the work piece.

7. The method of claim 6, wherein the work piece comprises a first substrate, epitaxial layers grown on the first substrate, and a second substrate bonded to the epitaxial layers.

8. The method of claim 7 wherein the heater is a resistance heater.

9. The method of claim 8, wherein the stage comprises a movable main stage and the resistance heater is disposed on the main stage.

10. The method of claim 9, wherein the stage further comprises:
an insulator between the main stage and the resistance heater;
a heater securing plate located on the resistance heater; and
securing pins securing the heater securing plate.

11. The method of claim 10, wherein the insulator, the heater securing plate and the securing pins are made of the same material selected from ceramics and plastics.

12. The method of claim 7, wherein the heater is one selected from an IR lamp and a heat gun.

## Patentansprüche

1. Verfahren zum Herstellen einer Leuchtdiode, umfassend:
Züchten epitaxialer Schichten auf einem ersten Substrat, wobei die epitaxialen Schichten eine Verbundhalbleiterschicht eines ersten Leitfähigkeitstyps, eine aktive Schicht und eine Verbundhalbleiterschicht eines zweiten Leitfähigkeitstyps umfassen,
Bonden eines zweiten Substrats, das einen anderen Wärmeausdehnungskoeffizienten besitzt als das erste Substrat, an die epitaxialen Schichten bei einer ersten Temperatur des ersten Substrats, die höher ist als Raumtemperatur, und
Trennen des ersten Substrats von den epitaxialen Schichten durch Richten eines Laserstrahl durch das erste Substrat hindurch bei einer zweiten Temperatur des ersten Substrats, die höher ist als Raumtemperatur, aber nicht höher ist als die erste Temperatur,
**dadurch gekennzeichnet, dass** das Bestrahlen mit dem Laserstrahl ausgeführt wird, während das erste Substrat abgekühlt wird, nachdem das zweite Substrat an die epitaxialen Schichten gebondet wurde.

2. Verfahren nach Anspruch 1, wobei das zweite Substrat durch eutektisches Bonden eines Bondmetalls an die epitaxialen Schichten gebondet wird.

3. Verfahren nach Anspruch 2, wobei das Bondmetall AuSn ist.

4. Verfahren nach Anspruch 3, wobei die zweite Temperatur im Bereich von 200-300 °C liegt.

5. Verfahren nach Anspruch 1, wobei eine Gesamtdicke der epitaxialen Schichten weniger als 10 *µ*m beträgt.

6. Verfahren nach einem der Ansprüche 1-5, das unter Verwendung einer Laser-Abhebevorrichtung angewendet wird, wobei die Laser-Abhebevorrichtung Folgendes umfasst:
einen Laseroszillator, der einen Laserstrahl aussendet,
einen Tisch, der ein Werkstück stützt, und
eine Heizvorrichtung, die das Werkstück erwärmt.

7. Verfahren nach Anspruch 6, wobei das Werkstück ein erstes Substrat, epitaxiale Schichten, die auf dem ersten Substrat gezüchtet sind, und ein zweites Substrat, das an die epitaxialen Schichten gebondet ist, umfasst.

8. Verfahren nach Anspruch 7, wobei die Heizvorrichtung eine Widerstandsheizvorrichtung ist.

9. Verfahren nach Anspruch 8, wobei der Tisch einen beweglichen Haupttisch umfasst und die Widerstandsheizvorrichtung auf dem Haupttisch angeordnet ist.

10. Verfahren nach Anspruch 9, wobei der Tisch des Weiteren Folgendes umfasst:
einen Isolator zwischen dem Haupttisch und der Widerstandsheizvorrichtung,
eine Heizvorrichtungs-Befestigungsplatte, die auf der Widerstandsheizvorrichtung angeordnet ist, und
Befestigungsstifte, welche die Heizvorrichtungs-Befestigungsplatte sichern.

11. Verfahren nach Anspruch 10, wobei der Isolator, die Heizvorrichtungs-Befestigungsplatte und die Befestigungsstifte aus dem gleichen Material bestehen, das aus Keramik und Kunststoff ausgewählt ist.

12. Verfahren nach Anspruch 7, wobei die Heizvorrichtung aus einer Infrarotlampe und einer Wärmepistole ausgewählt ist.

## Revendications

1. Procédé de fabrication d'une diode électroluminescente, comprenant de :
développer des couches épitaxiales sur un premier substrat, les couches épitaxiales comprenant une première couche semi-conductrice composite de type conducteur, une couche active, et une seconde couche semi-conductrice composite de type conducteur ;
lier un second substrat ayant un coefficient de dilatation thermique différent de celui du premier substrat aux couches épitaxiales à une première température du premier substrat supérieure à la température ambiante ; et
séparer le premier substrat des couches épitaxiales en irradiant un faisceau laser à travers le premier substrat à une seconde température du premier substrat supérieure à la température ambiante, mais pas supérieure à la première température,
**caractérisé en ce que**
l'irradiation du faisceau laser est effectuée pendant que le premier substrat est refroidi après que le second substrat a été lié aux couches épitaxiales.

2. Procédé selon la revendication 1, dans lequel le second substrat est lié aux couches épitaxiales par liaison eutectique d'un métal de liaison.

3. Procédé selon la revendication 2, dans lequel le métal de liaison est de l'AuSn.

4. Procédé selon la revendication 3, dans lequel la seconde température se situe dans la plage de 200 à 300 °C.

5. Procédé selon la revendication 1, dans lequel l'épaisseur totale des couches épitaxiales est inférieure à 10 µm.

6. Procédé selon l'une quelconque des revendications 1 à 5, appliqué en utilisant un appareil de décollement par laser, dans lequel l'appareil de décollement par laser comprend :
un oscillateur laser émettant un faisceau laser ;
une platine supportant une pièce de travail ; et
un dispositif de chauffage chauffant la pièce de travail.

7. Procédé selon la revendication 6, dans lequel la pièce de travail comprend un premier substrat, des couches épitaxiales développées sur le premier substrat, et un second substrat lié aux couches épitaxiales.

8. Procédé selon la revendication 7, dans lequel le dispositif de chauffage est un dispositif de chauffage par résistance.

9. Procédé selon la revendication 8, dans lequel la platine comprend une platine principale mobile et le dispositif de chauffage par résistance est disposé sur la platine principale.

10. Procédé selon la revendication 9, dans lequel la platine comprend en outre :
un isolant entre la platine principale et le dispositif de chauffage par résistance ;
une plaque de fixation de dispositif de chauffage située sur le dispositif de chauffage par résistance ; et
des goupilles de fixation fixant la plaque de fixation du dispositif de chauffage.

11. Procédé selon la revendication 10, dans lequel l'isolant, la plaque de fixation de dispositif de chauffage et les goupilles de fixation sont faits du même matériau choisi parmi les céramiques et les plastiques.

12. Procédé selon la revendication 7, dans lequel le dispositif de chauffage est l'un choisi parmi une lampe IR et un pistolet thermique.
